# DEMANDE DE BREVET EUROPEEN

(11) **EP 1 487 106 A1**
(43) Date de publication de la demande: **15.12.2004**
(21) Numéro de dépôt: 04364026.7
(22) Date de dépôt: 31.03.2004
(51) Int. Cl.: H03K 19/0185, G05F 3/26

(54) **Circuit intégré délivrant des niveaux logiques à une tension indépendante de la tension d'alimentation, sans régulateurs associé pour la partie puissance, et module de communication correspondant**

(30) Priorité: 01.04.2003 FR 0304075
(71) Demandeur: ATMEL NANTES SA, 44306 Nantes Cédex 3 (FR)
(72) Inventeur: M. Messager, Philippe, 44300 Nantes (FR)
(74) Mandataire: Vidon, Patrice

(57) **Abrégé**

L'invention concerne un circuit intégré comprenant des moyens pour délivrer sur au moins une sortie une tension de sortie prédéterminée représentative d'un niveau logique, des moyens de distribution d'une tension d'alimentation et des moyens de génération d'une tension interne de référence inférieure à ladite tension d'alimentation, comprenant des moyens de connexion de ladite tension d'alimentation sur ladite sortie et des moyens de limitation et/ou de détection de la tension sur ladite sortie à la valeur de ladite tension de sortie prédéterminée, tenant compte de ladite tension de référence.

## Description

### 1. Domaine de l'invention

Le domaine de l'invention est celui de la conception et de la fabrication de circuits intégrés, par exemple de type MOS.

Plus précisément, l'invention concerne les circuits délivrant des niveaux logiques, dont la tension doit rester invariable même lorsque la tension d'alimentation varie.

Notamment, l'invention concerne la communication entre deux circuits intégrés, par exemple via une liaison USB. Un buffer USB doit en effet fournir des effets logiques « 1 » et « 0 » en sortie, sur une liaison pouvant atteindre 500 pF de capacité, avec un temps de commutation de l'ordre de 20 ns. Or, la norme USB spécifie que le niveau « 1 » doit être une tension de 3 V, quelle que soit la tension de l'alimentation.

### 2. État de l'art

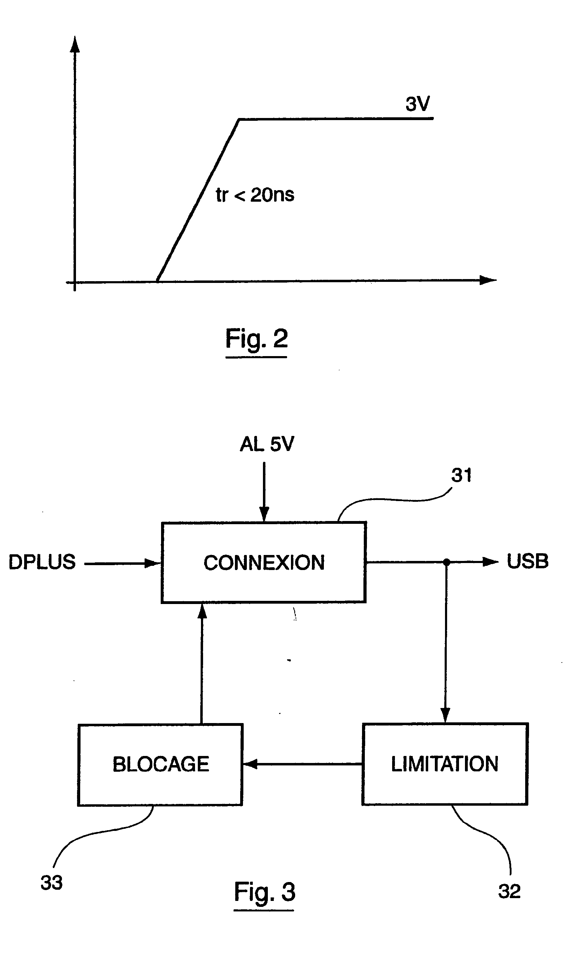

Habituellement, un buffer USB n'est qu'un commutateur (« switch » en anglais) de puissance et est alimenté par un régulateur délivrant toujours 3 V. Ce régulateur doit donc avoir une capacité très importante en sortie 15, pour pouvoir encaisser les pics de courant, de l'ordre de 100 mA pendant 20 ns. En effet, celui-ci ne pourrait pas réagir en 20 ns (comme illustré en figure 2) sans cette capacité, et la tension s'abaisserait alors fortement sans cette dernière.

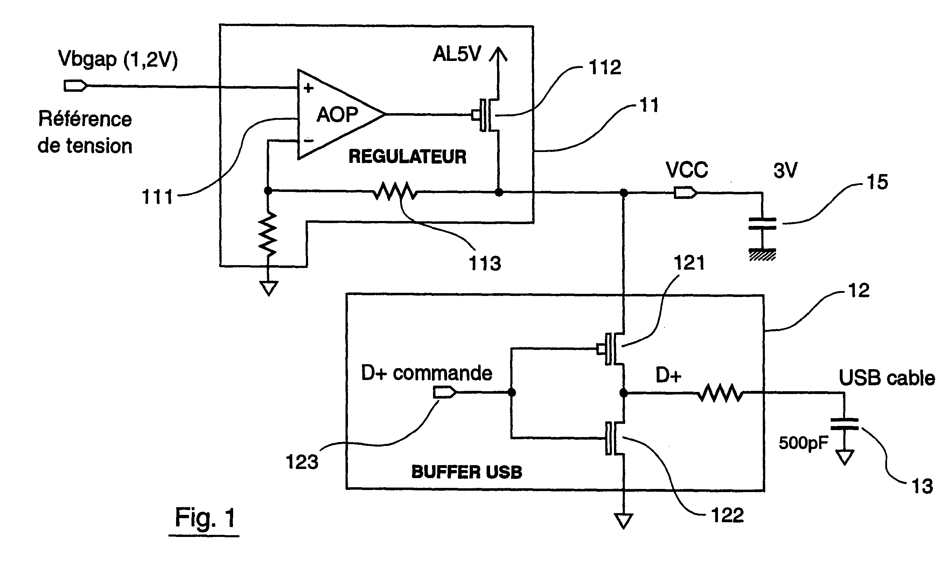

La figure 1 illustre un tel dispositif.

Il comprend donc un régulateur 11, comprenant un amplificateur opérationnel 111 et recevant sur sa borne positive une référence de tension Vbgap, par exemple de 1,2 V. Cet amplificateur 111 opérationnel est connecté à un transistor 112, ce dernier rebouclant sur l'entrée négative de ce premier, par l'intermédiaire d'une résistance 113. Ce régulateur délivre donc une tension VCC à réguler de 3 V, à l'aide de la capacité externe 14, qui est notamment dirigée vers le buffer 12.

Ce buffer comprend deux transistors 121 et 122, respectivement PMOS et NMOS, recevant un signal de commande 123, et délivrant sur une résistance 124 l'invention correspondant au niveau logique souhaité.

Comme mentionné plus haut, pour obtenir un temps de réponse inférieur à 20 ns, il est nécessaire de prévoir une capacité externe 13, par exemple d'une valeur de 500 pF. Cela nécessite de prévoir une borne de sortie spécifique sur le circuit intégré, pour connecter cette capacité externe 13.

En outre, une telle capacité augmente le coût de l'ensemble, ainsi que son encombrement, et la complexité de montage.

Par ailleurs, un régulateur, supposant la présence d'un amplificateur opérationnel, entraîne un encombrement important sur la surface du circuit intégré.

### 3. Objectifs de l'invention

L'invention a notamment pour objectif de pallier ces différents inconvénients de l'état de l'art.

Plus précisément, un objectif de l'invention est de fournir un circuit intégré capable de délivrer une tension de sortie prédéterminée représentative d'un niveau logique, quelle que soit la tension d'alimentation, ne nécessitant aucun composant externe et notamment de capacité pour encaisser des pics de courant.

Un autre objectif de l'invention est de fournir un tel circuit intégré, ne nécessitant pas la présence d'un régulateur USB classique supposant la présence d'un amplificateur opérationnel.

Encore un autre objectif de l'invention est de fournir un tel circuit intégré, permettant de simplifier la conception, la fabrication et le montage du circuit intégré.

En d'autres termes, un objectif de l'invention est de fournir une technique simple et efficace, peu consommatrice en surface de silicium, pour réaliser un tel circuit intégré.

L'invention a également pour objectif de fournir un tel circuit intégré, offrant un temps de montée très court jusqu'à la tension souhaitée, par exemple de l'ordre de 20 ns.

### 4. Caractéristiques principales de l'invention

L'invention concerne donc un circuit intégré comprenant des moyens pour délivrer sur au moins une sortie une tension de sortie prédéterminée représentative d'un niveau logique, ledit circuit intégré comprenant des moyens de distribution
d'une tension d'alimentation et des moyens de génération d'une tension interne de référence inférieure à ladite tension d'alimentation.

Un tel circuit comprend en particulier des moyens de connexion de ladite tension d'alimentation sur ladite sortie et des moyens de limitation et/ou de détection de la tension sur ladite sortie à la valeur de ladite tension de sortie prédéterminée, tenant compte de ladite tension de référence.

Ainsi, il est possible d'obtenir une tension de sortie précise, quelles que soient les variations de la tension d'alimentation, sans élément externe tel qu'une capacité.

Avantageusement, la tension prédéterminée est égale à la tension de référence.

Cependant, dans un autre mode de réalisation de l'invention, il est possible de générer une tension de sortie qui soit différente de la tension de référence, tout en assurant les mêmes fonctionnalités, en utilisant par exemple, un ou plusieurs transistors montées) en série.

De façon préférentielle, lorsque la tension prédéterminée est atteinte, les courants circulant dans les moyens de connexion de la tension d'alimentation et dans les moyens de limitation et/ou de détection de la tension s'équilibrent.

Préférentiellement, les moyens de connexion comprennent un premier transistor (TP0) de puissance.

Avantageusement, le drain du premier transistor est connecté à la sortie et sa source à la tension d'alimentation.

De façon avantageuse, les moyens de limitation de la tension comprennent au moins un second transistor (TP1) contrôlé sur sa grille par la tension de référence.

Préférentiellement, la grille du second transistor est connectée à la grille d'un troisième transistor (TP2) monté en diode à la tension de référence.

De façon préférentielle, les moyens de limitation de la tension comprennent des moyens de blocage du premier transistor, lorsque la tension prédéterminée est atteinte.

De façon également préférentielle, les moyens de blocage comprennent un premier et un second miroir de courant (TN1/TN2, TP4/TP5) connectés l'un à l'autre.

Avantageusement, le premier miroir de courant délivre un courant de blocage lorsque la tension prédéterminée est atteinte sur la sortie, et en ce que le second miroir transmet une copie du courant de blocage sur la grille du premier transistor, de façon à le bloquer.

De façon avantageuse, la grille du premier transistor est connectée à une entrée de commande via un quatrième transistor (TN3).

De façon également avantageuse, la taille du troisième transistor est inférieure à celle des transistors (TP4, TP5) du second miroir, de façon que ce dernier impose son niveau au troisième transistor lorsqu'il délivre la copie du courant de blocage.

De façon préférentielle, la tension de sortie correspond au niveau logique « 1 » d'une liaison USB.

Avantageusement, la tension de référence est utilisée pour contrôler la partie CMOS logique du circuit intégré.

De façon avantageuse, la tension de référence et/ou la tension prédéterminée valent 3 V, la tension d'alimentation valant 5 V.

L'invention concerne également un module de communication pour circuit intégré comprenant des moyens pour délivrer sur une au moins une sortie une tension de sortie prédéterminée représentative d'un niveau logique et un circuit intégré comprenant des moyens de distribution d'une tension d'alimentation et des moyens de génération d'une tension interne de référence inférieure à la tension d'alimentation. Ce module comprend, avantageusement, des moyens de connexion de la tension d'alimentation sur la sortie et des moyens de limitation de la tension sur la sortie à la valeur de la tension de sortie prédéterminée, tenant compte de ladite tension de référence.

### 5. Liste des figures

D'autres caractéristiques et avantages de l'invention apparaîtront plus clairement à la lecture de la description suivante d'un mode de réalisation préférentielle, donné à titre de simple exemple illustratif et non limitatif et des figures annexées, parmi lesquelles :
- la figure 1 est un schéma illustrant un dispositif à régulateur selon l'art antérieur comprenant une capacité externe, et commenté en préambule ;
- la figure 2 illustre la tension du signal de sortie, tant selon l'art antérieur que selon l'invention ;
- la figure 3 est un schéma de principe de la technique selon l'invention ;
- la figure 4 est un exemple détaillé de mise en oeuvre de la technique selon l'invention ;
- les figures 5.a et 5.b illustrent des courbes de valeurs associées au fonctionnement du dispositif de la figure 4.

### 6. Description d'un mode de réalisation préférentiel de l'invention

### 6.1 Principe général

Le principe général de l'invention consiste à générer la tension de 3 V dans le circuit intégré, sans avoir besoin d'un régulateur pour la partie puissance. En général, il y a en effet un régulateur dans les circuits pour la partie CMOS logique, afin que celle-ci fonctionne toujours à tension faible (3 V, et non 5,5 V, pour éviter les risques de destruction des transistors de petite dimension).

Selon un aspect avantageux de l'invention, on prévoit donc de se servir de cette tension de 3 V comme référence pour générer un niveau logique « 1 », selon la norme USB (dans le mode de réalisation décrit), en prenant la puissance directement sur l'alimentation 5 V. La figure 3 illustre de façon simplifiée le principe général de l'invention.

Le système de l'invention comprend donc des moyens de connexion 31 de l'alimentation 5 V sur la sortie USB. Ces moyens de connexion comprennent notamment un transistor PMOS, reliant cette alimentation 5 V à la sortie USB.

Des moyens de limitation 32 de la tension délivrée sur cette sortie USB sont prévus. Ils sont connectés à cette sortie, de façon à absorber une partie de la tension, lorsque cela est nécessaire, de façon que celle-ci ne dépasse pas 3 V.

Ces moyens de limitation 32 contrôlent simultanément des moyens de blocage 33, comprenant par exemple deux miroirs de courant. Ils agissent sur le moyen de connexion, de façon à bloquer la liaison entre l'alimentation 5 V et la sortie USB.

Ainsi, il est possible de délivrer une sortie USB à une tension régulière de 3 V, sans capacité externe, ni amplificateur opérationnel, ni autre élément complexe.

### 6.2 Présentation d'un mode de mise en oeuvre particulier de l'invention

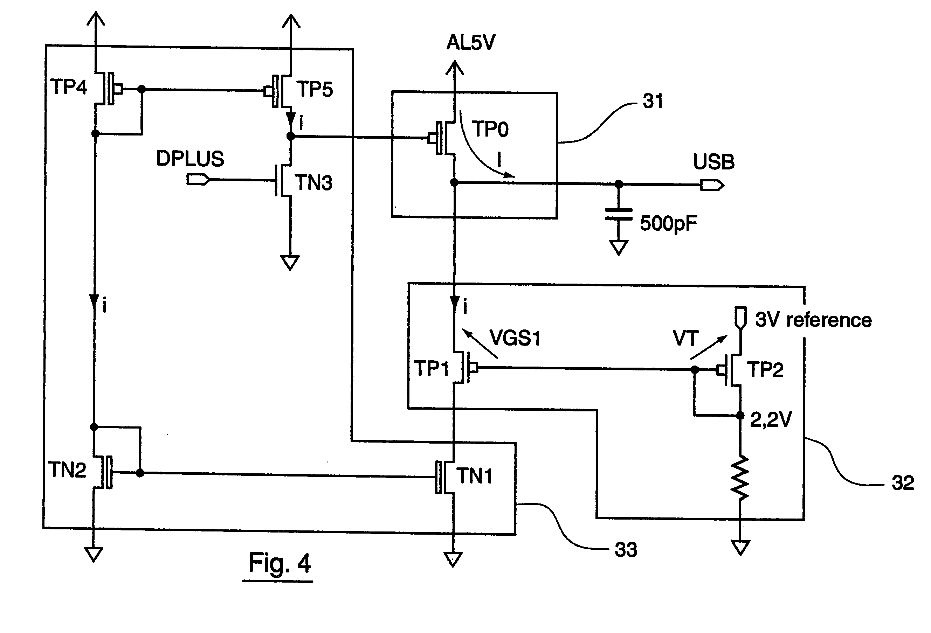

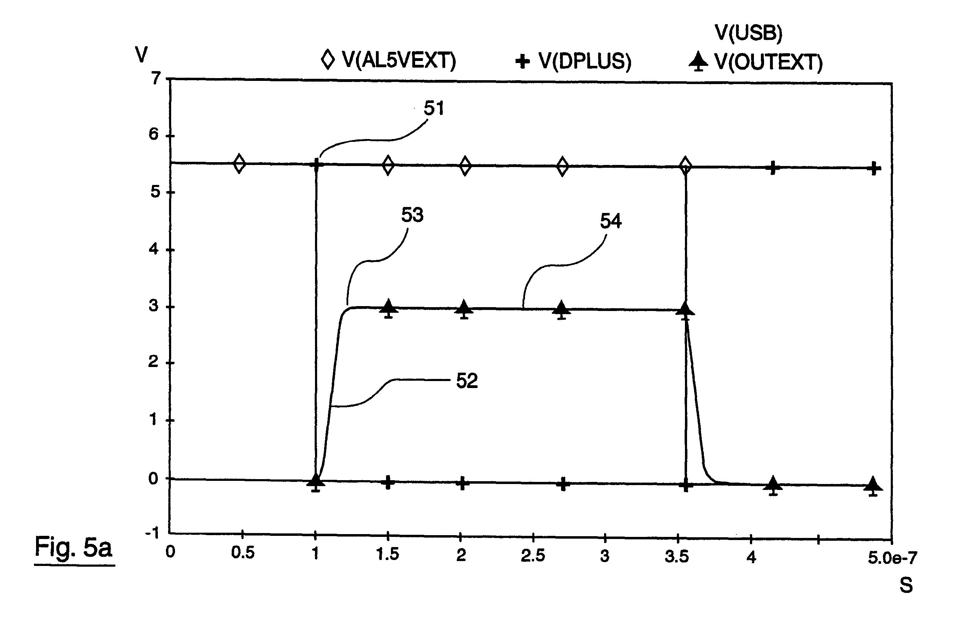

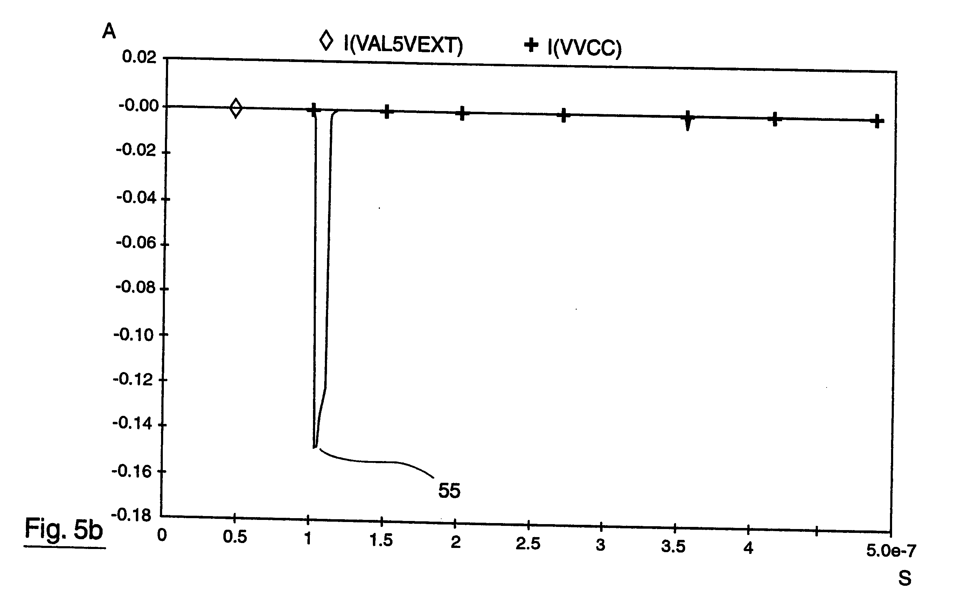

On présente maintenant un exemple particulier de mise en oeuvre de ces techniques, à l'aide de la figure 4 présentant un mode particulier de réalisation de l'invention et de la figure 5 (a et b) illustrant certaines valeurs de fonctionnement.

Le transistor TP0 (PMOS dans cet exemple, mais il est bien sûr possible d'inverser les rôles des transistors PMOS et NMOS) relie l'alimentation 5 V AL5V à la sortie USB. Il devient passant en fonction du signal qu'il reçoit sur sa grille, contrôlé comme expliqué par la suite.

Selon l'invention, on connecte un transistor TP1 (PMOS) sur la sortie USB par son drain. Sa grille est reliée à une tension VT inférieure à la tension USB (et valant par exemple environ 2,2 V).

Cette tension VT peut être réalisée à l'aide d'un transistor TP2 de même type que TP1, connecté en diodes à la tension 3 V numériques (toujours disponible dans la partie CMOS logique d'un circuit intégré). Ce transistor génère donc une tension égale à (3 V - VT). Ce transistor TP1 a ainsi une fonction de détecteur instantané de niveau « 1 » (3 V) sur la sortie USB. En effet, dès que la tension sur la sortie USB dépasse 3V, la tension VGS1 de ce transistor TP1 devient supérieure à VT (qui vaut environ 0,8 V) et devient donc passant.

Un courant i parcourt alors ce transistor TP1. Grâce à ce courant i, on peut fermer le transistor de puissance TP0, par l'intermédiaire de moyens de blocage, qui connectent la sortie USB à l'alimentation 5 V. Il est donc ainsi aisé de limiter le niveau « 1 » de l'USB à 3 V.

Un simple comparateur comparant la sortie USB à la tension 3 V numérique, pour fermer ensuite le transistor de puissance TP0, serait trop lent, et créerait des surtensions (« overshoots » en anglais) et consommerait en outre beaucoup. La solution, selon l'invention, met en oeuvre des miroirs de courant dans les moyens de blocage et permet de pallier efficacement cet inconvénient.

Il est à noter que le principe décrit ci-dessus fonctionne également avec les transistors NMOS au lieu des transistors PMOS, TP0 et TP1.

### 6.3 Illustration du fonctionnement du dispositif de la figure 4

Lorsqu'on désire un niveau « 1 » sur la sortie USB, la commande DPLUS passe à « 1 » (51, figure 5.a). Le transistor TN3 ouvre alors le transistor de puissance TP0, en imposant une tension VSS sur sa grille. La tension sur la sortie USB monte alors progressivement (52, figure 5.a). Lorsqu'elle atteint 3 V, au bout d'environ 20ns (53, figure 5.a), le transistor TP1 devient légèrement conducteur, puisque sa tension VGS1 est devenue supérieure à la tension VT. Le courant venant du transistor TP0 vers le transistor TP1 est alors recopié instantanément par le miroir de courant formé par les transistors TN1 et TN2, puis par le miroir de courant formé par les transistors TP4/TP5.

Ainsi, lorsqu'un courant circule dans TP1, il y a un courant similaire circulant dans TP5. Ce courant permet de fermer le transistor TP0, en ramenant sa tension de grille à 5V - VT, ce qui entraîne sa fermeture, au moins partiellement.

Le transistor TP5 est configuré de façon qu'il puisse imposer son niveau au transistor TN3, ce dernier étant un transistor très faible.

Ainsi, le système charge la capacité USB jusqu'à 3 V, et maintient ensuite ce niveau (54, figure 5.a), en équilibrant les courants, de l'ordre de quelques dizaines de µA dans les transistors TP0 et TP1. Toute la puissance pour charger les 500 pF de l'USB viennent ainsi directement de la tension d'alimentation AL5V (55, figure 5.b). Il n'y a donc pas besoin d'utiliser de régulateur USB, ni de capacité extérieure, dans la solution selon l'invention.

### 6.4 Applications

Le dispositif de l'invention peut être implanté dans tous les cas où les capacités extérieures doivent être diminuées au maximum, et par exemple pour des liaisons USB. Il s'applique notamment dans les cas où le circuit intégré possède une référence de tension interne ayant la même valeur que la tension à délivrer en sortie, via des buffers.

### 6.5 Généralisation

Dans un mode de réalisation particulier de l'invention, on utilise un ou plusieurs autres transistors montés en série avec le transistor TP2, ou bien encore, un régulateur de puissance réduite (1,2 V par exemple), de façon à générer une tension de sortie USB (de 2 V par exemple) qui soit différente de la tension de référence, toute en assurant les mêmes fonctionnalités.

## Revendications

1. Circuit intégré comprenant des moyens pour délivrer sur au moins une sortie une tension de sortie prédéterminée représentative d'un niveau logique,
ledit circuit intégré comprenant des moyens de distribution d'une tension d'alimentation et des moyens de génération d'une tension interne de référence inférieure à ladite tension d'alimentation,
**caractérisé en ce qu'**il comprend des moyens de connexion de ladite tension d'alimentation sur ladite sortie et des moyens de limitation et/ou de détection de la tension sur ladite sortie à la valeur de ladite tension de sortie prédéterminée, tenant compte de ladite tension de référence.

2. Circuit intégré selon la revendication 1, **caractérisé en ce que** ladite tension prédéterminée est égale à ladite tension de référence.

3. Circuit intégré selon l'une quelconque des revendications 1 et 2, **caractérisé en ce que**, lorsque ladite tension prédéterminée est atteinte, les courants circulant dans lesdits moyens de connexion de ladite tension d'alimentation et lesdits moyens de limitation et/ou de détection de la tension s'équilibrent.

4. Circuit intégré selon l'une quelconque des revendications 1 à 3, **caractérisé en ce que** lesdits moyens de connexion comprennent un premier transistor (TP0) de puissance.

5. Circuit intégré selon la revendication 4, **caractérisé en ce que** le drain dudit premier transistor est connecté à ladite sortie et sa source à ladite tension d'alimentation.

6. Circuit intégré selon l'une quelconque des revendications 1 à 5, **caractérisé en ce que** lesdits moyens de limitation de la tension comprennent au moins un second transistor (TP1) contrôlé sur sa grille par ladite tension de référence.

7. Circuit intégré selon la revendication 6, **caractérisé en ce que** ladite grille du second transistor est connectée à la grille d'un troisième transistor (TP2) monté en diode à ladite tension de référence.

8. Circuit intégré selon l'une quelconque des revendications 4 à 7, **caractérisé en ce que** lesdits moyens de limitation de la tension comprennent des moyens de blocage dudit premier transistor, lorsque ladite tension prédéterminée est atteinte.

9. Circuit intégré selon la revendication 8, **caractérisé en ce que** lesdits moyens de blocage comprennent un premier et un second miroir de courant (TN1/TN2, TP4/TP5) connectés l'un à l'autre.

10. Circuit intégré selon la revendication 9, **caractérisé en ce que** le premier miroir de courant délivre un courant de blocage lorsque ladite tension prédéterminée est atteinte sur ladite sortie, et **en ce que** ledit second miroir transmet une copie dudit courant de blocage sur la grille dudit premier transistor, de façon à le bloquer.

11. Circuit intégré selon l'une quelconque des revendications 4 à 10, **caractérisé en ce que** la grille dudit premier transistor est connectée à une entrée de commande via un quatrième transistor (TN3).

12. Circuit intégré selon les revendications 10 et 11, **caractérisé en ce que** la puissance dudit troisième transistor est inférieure à celle des transistors (TP4, TP5) dudit second miroir, de façon que ce dernier impose son niveau audit troisième transistor lorsqu'il délivre ladite copie du courant de blocage.

13. Circuit intégré selon l'une quelconque des revendications 1 à 12, **caractérisé en ce que** ladite tension de sortie correspond au niveau logique « 1 » d'une liaison USB.

14. Circuit intégré selon l'une quelconque des revendications 1 à 13, **caractérisé en ce que** ladite tension de référence est utilisée pour alimenter la partie CMOS logique dudit circuit intégré.

15. Circuit intégré selon l'une quelconque des revendications 1 à 14, **caractérisé en ce que** ladite tension de référence et/ou ladite tension prédéterminée valent 3 V, ladite tension d'alimentation valant 5 V.

16. Module de communication pour circuit intégré comprenant des moyens pour délivrer sur une au moins une sortie une tension de sortie prédéterminée représentative d'un niveau logique,
ledit circuit intégré comprenant des moyens de distribution d'une tension d'alimentation et des moyens de génération d'une tension interne de référence inférieure à ladite tension d'alimentation,
**caractérisé en ce qu'**il comprend des moyens de connexion de ladite tension d'alimentation sur ladite sortie et des moyens de limitation de la tension sur ladite sortie à la valeur de ladite tension de sortie prédéterminée, tenant compte de ladite tension de référence.
